# EUROPEAN PATENT APPLICATION

(11) **EP 3 933 890 A1**
(43) Date of publication of application: **05.01.2022**
(21) Application number: 20846284.6
(22) Date of filing: 26.05.2020
(51) Int. Cl.: H01L 21/304, H01L 21/306, C30B 29/40

(54) **INDIUM PHOSPHIDE SUBSTRATE AND METHOD FOR MANUFACTURING INDIUM PHOSPHIDE SUBSTRATE**

(30) Priority: 26.07.2019 JP 2019138231
(71) Applicant: JX Nippon Mining & Metals Corporation, Tokyo 105-8417 (JP)
(72) Inventor: ITANI, Kenya, Kitaibaraki-shi, Ibaraki 319-1535 (JP); KURITA, Hideki, Kitaibaraki-shi, Ibaraki 319-1535 (JP); HAYASHI, Hideaki, Kitaibaraki-shi, Ibaraki 319-1535 (JP)
(74) Representative: Yeadon IP Limited
(86) International application number: PCT/JP2020/020789
(87) International publication number: WO 2021/019887

(57) **Abstract**

Provided is an indium phosphide substrate having good accuracy of flatness of the orientation flat, and a method for producing the indium phosphide substrate. An indium phosphide substrate having a main surface and an orientation flat, wherein a difference between maximum and minimum values of a maximum height Pz in each of four cross-sectional curves is less than or equal to 1.50/10000 of a length in a longitudinal direction of an orientation flat end face, wherein the four cross-sectional curves are set at intervals of one-fifth of a thickness of the substrate on a surface excluding a width portion of 3 mm inward from both ends of the orientation flat end face in the longitudinal direction of the orientation flat end face, and the maximum height Pz in each of the four cross-sectional curves is measured in accordance with JIS B 0601: 2013.

## Description

### FIELD OF THE INVENTION

The present invention relates to an indium phosphide substrate, and a method for producing an indium phosphide substrate.

### BACKGROUND OF THE INVENTION

Indium phosphide (InP) is a Group III-V compound semiconductor material composed of indium (In) of Group III and phosphorus (P) of Group V. The semiconductor material has characteristics in which a band gap is 1.35 eV, and an electron mobility is -5400 cm²/V·s, and the electron mobility under a high electric field is higher than that of other general semiconductor materials such as silicon and gallium arsenide. Further, the semiconductor material has characteristics in which its stable crystal structure under ordinary temperature and ordinary pressure is a cubic sphalerite type structure, and its lattice constant is larger than that of a compound semiconductor such as gallium arsenide (GaAs) and gallium phosphide (GaP).

An indium phosphide ingot which is a raw material for the indium phosphide substrate is generally sliced to have a predetermined thickness, ground to have a desired shape, mechanically polished as needed, and then subjected to etching or precision polishing in order to remove polishing debris and damage caused by polishing.

A common practice for indicating a crystal orientation of an indium phosphide substrate is an orientation flat method, for example, as disclosed in Patent Document 1, which cuts out a bow-shaped portion of a predetermined region of a circular substrate (wafer) to expose a surface having a specific plane orientation. A short line segment indicating the orientation is called an orientation flat. In a wafer process, the orientation of the wafer is determined based on the orientation flat to perform various steps.

### CITATION LIST

### Patent Literatures

[Patent Literature 1] Japanese Patent Application Publication No. 2014-028723 A

### SUMMARY OF THE INVENTION

### Technical Problem

In the wafer process, the orientation flat as described above is used as a reference to determine the orientation of the wafer, and its accuracy is important. In particular, flatness of the orientation flat is very important when two parallel pillar shaped jigs are pressed against the orientation flat and the orientation flat is used as a reference to determine the orientation of the wafer.

However, in the orientation flat method which cuts a bow-shaped portion of a predetermined region of a circular indium phosphide substrate (wafer) to expose a surface having a specific plane orientation, it is generally difficult to improve the accuracy of the flatness of the orientation flat. Therefore, there is a need for a technique of improving the accuracy of the flatness of the orientation flat.

The present invention has been made to solve the above problems. An object of the present invention is to provide an indium phosphide substrate having good accuracy of flatness of the orientation flat, and a method for producing the indium phosphide substrate.

### Solution to Problem

In an embodiment, the present invention relates to an indium phosphide substrate having a main surface and an orientation flat, wherein a difference between maximum and minimum values of a maximum height Pz in each of four cross-sectional curves is less than or equal to 1.50/10000 of a length in a longitudinal direction of an orientation flat end face, wherein the four cross-sectional curves are set at intervals of one-fifth of a thickness of the substrate on a surface excluding a width portion of 3 mm inward from both ends of the orientation flat end face in the longitudinal direction of the orientation flat end face, and the maximum height Pz in each of the four cross-sectional curves is measured in accordance with JIS B 0601: 2013.

In an embodiment of the indium phosphide substrate according to the present invention, the difference between the maximum and minimum values of the maximum height Pz in each of the four cross-sectional curves is less than or equal to 1.41/10000 of the length in the longitudinal direction of the orientation flat end face.

In another embodiment, the present invention relates to an indium phosphide substrate having a main surface and an orientation flat, wherein a standard deviation σ of maximum heights Pz in four cross-sectional curves is less than or equal to 1.50 µm, wherein the four cross-sectional curves are set at intervals of one-fifth of a thickness of the substrate on a surface excluding a width portion of 3 mm inward from both ends of the orientation flat end face in a longitudinal direction of an orientation flat end face, and the maximum height Pz in each of the four cross-sectional curves is measured in accordance with JIS B 0601: 2013.

In yet another embodiment of the indium phosphide substrate according to the present invention, the standard deviation σ of the maximum heights Pz in the four cross-sectional curves is less than or equal to 1.22 µm.

In another embodiment, the indium phosphide substrate according to the present invention has a thickness of from 300 to 900 µm.

In yet another embodiment of the indium phosphide substrate according to the present invention, a length of a ridge line which is a line where the main surface is in contact with the orientation flat is from 8 to 50% of a diameter of the main surface.

In yet another embodiment of the indium phosphide substrate according to the present invention, an outer edge of the main surface comprises the orientation flat and a circular arc portion connected to the orientation flat, and wherein a maximum diameter of the main surface is more than or equal to the length of the ridge line, and is from 49 to 151 mm.

In another embodiment, the present invention relates to a method for producing an indium phosphide substrate, comprising the steps of: grinding an ingot of indium phosphide at a grinding wheel feed rate of 20 to 35 mm/min using a grinding wheel having a grit size of #270 to #400 to form an orientation flat; cutting out at least one wafer having a main surface and an orientation flat from the ground ingot of indium phosphide; chamfering an outer circumference portion of the wafer other than end faces of forming the orientation flat; polishing at least one surface of the chamfered wafer; and etching the polished wafer under the following etching conditions:
- etching conditions:

### (Composition of Etching Solution)

when the composition comprises 85% by mass of aqueous phosphoric acid solution and 30% by mass of hydrogen peroxide solution, the composition has a volume ratio of the aqueous phosphoric acid solution: the hydrogen peroxide of 0.2 to 0.4: 0.1, the balance being water so as to add up to 1 as the total etching solution;

### (Temperature of Etching Solution)

from 60 to 100 °C;

### (Etching Time)

from 8 to 15 minutes.

In another embodiment, the present invention relates to a method for producing an indium phosphide substrate, comprising the steps of: grinding an ingot of indium phosphide to form an orientation flat; cutting out at least one wafer having a main surface and an orientation flat from the ground ingot of indium phosphide; griding end faces of the orientation flat on the wafer at a grinding wheel feed rate of 60 to 180 mm/min using a grinding wheel having a grit size of #800 to #1200 and chamfering an outer circumference portion other than the orientation flat; polishing at least one surface of the chamfered wafer; and etching the polished wafer under the following etching conditions:
- etching conditions:

### (Composition of Etching Solution)

when the composition comprises 85% by mass of aqueous phosphoric acid solution and 30% by mass of hydrogen peroxide solution, the composition has a volume ratio of the aqueous phosphoric acid solution: the hydrogen peroxide of 0.2 to 0.4: 0.1, the balance being water so as to add up to 1 as the total etching solution;

### (Temperature of Etching Solution)

from 60 to 100 °C;

### (Etching Time)

from 8 to 15 minutes.

### Advantageous Effects of Invention

According to the embodiments of the present invention, it is possible to provide an indium phosphide substrate having good accuracy of flatness of the orientation flat, and a method for producing the indium phosphide substrate.

### BRIEF DESCRIPTION OF THE DRAWINGS

FIG. 1 is a schematic external view of an indium phosphide substrate according to an embodiment of the present invention and an enlarged schematic view of an orientation flat; and
FIG. 2 is a schematic view showing each step of a first production method and a second production method for an indium phosphide substrate according to an embodiment of the present invention, and an ingot or a wafer produced in each step.

### DETAILED DESCRIPTION OF THE INVENTION

### [Indium Phosphide Substrate]

First, a structure of an indium phosphide substrate according to the present embodiment will be described.

An indium phosphide substrate 10 according to the present embodiment has a main surface 11 and an orientation flat 12. Further, a line where the main surface 11 is in contact with the orientation flat 12 is a ridge line 13.

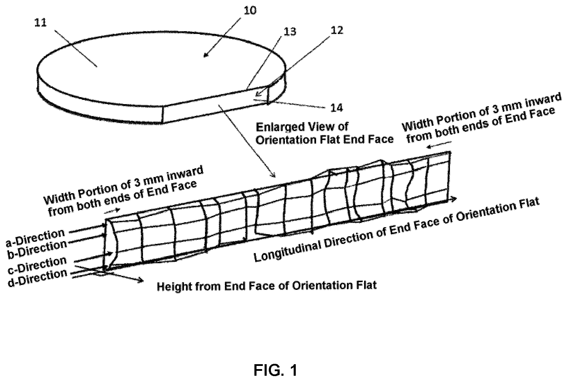

As used herein, the "main surface" refers to a surface which actually carries out epitaxial growth when used as a substrate for epitaxial growth to form a semiconductor device structure. The "orientation flat" is a portion that appears after an outer circumference portion of a crystal is cut out into, for example, a bow shape, and corresponds to a straight portion formed on a part of the outer circumference when the main surface of the substrate is viewed from above. The orientation flat mainly serves to indicate a crystal orientation of the substrate. The orientation flat is formed in a direction perpendicular to the main surface of the substrate when visually observed. As used herein, the "orientation flat end face" refers to a surface that forms the orientation flat (an end face 14 of the indium phosphide substrate in FIG. 1).

Plane orientations of the main surface 11 and the orientation flat 12 of the indium phosphide substrate 10 according to an embodiment of the present invention may be, for example, a <110> orientation proximate from the (100) plane or a plane inclined to the <110> orientation in a range of 0° to 5° for the main surface 11, and an equivalent plane consisting of (0-1-1), (0-11), (011) and (01-1) planes for the orientation flat 12. Strictly speaking, for example, the orientation flat of the wafer having a main surface inclined by 5° in the [111] orientation from the (100) plane will be a plane inclined by 5° from the (0-1-1) plane. Further, the embodiment of the present invention may also be applied to a case of having the orientation flat in the direction rotated by 45°, in addition to the (011) plane, and is not limited as long as the plane is any particular plane that is substantially perpendicular to the main surface 11 of the indium phosphide substrate 10, as described above. Further, although the present invention relates to a technique for producing the orientation flat of indium phosphide substrates, it is not limited to techniques for producing orientation flats applies to circular indium phosphide substrates, and is effective for improving the flatness of the end face of the orientation flat applied to a rectangular substrate, and can be applied to rectangular substrates as well.

The orientation flat 12 of the indium phosphide substrate 10 may be formed from a portion that appears after cutting a part of the outer circumference of the circular substrate into the bow shape. In this case, an outer edge of the main surface 11 is comprised of the orientation flat 12 and a circular arc portion connected to the orientation flat 12. In this case, a maximum diameter of the main surface 11 may be from 49 to 151 mm or from 49 to 101 mm. The maximum diameter of the main surface 11 is more than or equal to the length of the ridge line. The indium phosphide substrate 10 may be a rectangle shape, such as a square.

The length of the ridge line 13 where the main surface 11 is in contact with the orientation flat 12 is not particularly limited as long as it is a length sufficient to ensure an area of the main surface 11. The length is preferably 8 to 50% of a wafer diameter (a diameter of the main surface 11). If the length of the ridge line 13 where the main surface 11 is in contact with the orientation flat 12 is less than 8% of the wafer diameter (the diameter of the main surface 11), it may be difficult to confirm the existence of the orientation flat (OF). If the length of the ridge line 13 where the main surface 11 is in contact with the orientation flat 12 is more than 50% of the wafer diameter (the diameter of the main surface 11), it may cause a problem of reducing the effective area of the wafer. The length of the ridge 13 where the main surface 11 is in contact with the orientation flat 12 is more preferably 10 to 40% of the wafer diameter (the diameter of the main surface 11), and even more preferably 20 to 40%.

The indium phosphide substrate 10 preferably a thickness of, for example, from 300 to 900 µm, and more preferably from 300 to 700 µm, although not particularly limited thereto. If the thickness of the indium phosphide substrate 10 is less than 300 µm, it may crack, especially when the diameter is larger, and if it is more than 900 µm, a problem of wasting base metal crystals may be caused.

In one aspect, for the indium phosphide substrate 10, when four cross-sectional curves are set at intervals of one-fifth of a thickness of the substrate on a surface excluding a width portion of 3 mm inward from both ends of the orientation flat end face 14 in the longitudinal direction of the orientation flat end face 14, and the maximum height Pz in each of the four cross-sectional curves is measured in accordance with JIS B 0601: 2013, a difference between maximum and minimum values of the maximum height Pz in each of the four cross-sectional curves is controlled to be less than 1.50/10000 of the length in the longitudinal direction of the orientation flat end face 14.

The difference between the maximum and minimum values of the maximum height Pz in each of the four cross-sectional curves will be described in more detail using the drawings. FIG. 1 shows an enlarged schematic view of the orientation flat. First, in the longitudinal direction of the orientation flat end face 14, the surface is set that excludes the width portion of 3 mm inward from both ends of the orientation flat end face 14. The four cross-sectional curves are then set at intervals of one-fifth of the thickness of the substrate. In FIG. 1, the four cross-sectional curves set are the a-direction cross-sectional curve, the b-direction cross-sectional curve, the c-direction cross-sectional curve, and the d-direction cross-sectional curve. The maximum height Pz defined in JIS B 0601: 2013 in each of the four cross-sectional curves in the a-direction, b-direction, c-direction, and d-direction is measured. The difference between the maximum and minimum values of each of the maximum heights Pz in the four cross-sectional curves in the a-, b-, c-, and d-directions is then determined.

The maximum height Pz defined in JIS B 0601 in the cross-sectional curve is expressed as the sum of the maximum values of mountain height and valley depth.

The indium phosphide substrate 10 is controlled so that the difference between the maximum and minimum value of the maximum height Pz in each of the four cross-sectional curves is less than 1.50/10000 of the length in the longitudinal direction of the orientation flat end face 14. According to this configuration, when the orientation flat 12 is used as a reference for determining the orientation of the wafer by pressing two parallel pillar shaped jigs against the orientation flat 12, the flatness accuracy of the orientation flat 12 is improved and the wafer can be accurately set in the desired orientation. It should be noted that FIG. 1 is created for illustrative purposes only, and does not accurately show any actual positional relationship between the orientation flat end face and the cross-sectional curve, or the interval between the cross-sectional curves.

The difference between the maximum and minimum values of the maximum height Pz in each of the four cross-sectional curves is preferably less than 1.41/10000 of the length in the longitudinal direction of the orientation flat end face 14.

In another aspect of the indium phosphide substrate 10, when the four cross-sectional curves are set at intervals of one-fifth of the thickness of the substrate on a surface excluding a width portion of 3 mm inward from both ends of the orientation flat end face 14 in the longitudinal direction of the orientation flat end face 14, and each of maximum heights Pz defined in JIS B 0601:2013 is measured, a standard deviation σ of the maximum heights Pz in the four cross-sectional curves is controlled to be 1.50 µm or less. According to this configuration, when the orientation flat 12 is used as a reference to determine the orientation of the wafer by pressing two parallel pillar shaped jigs against the orientation flat 12, the flatness accuracy of the orientation flat 12 can be improved, and the wafer can be accurately set in the desired orientation.

The standard deviation σ of the maximum heights Pz in the four cross-sectional curves is preferably 1.22 µm or less, and more preferably 0.6 µm or less.

### [Method for Producing Indium Phosphide Substrate]

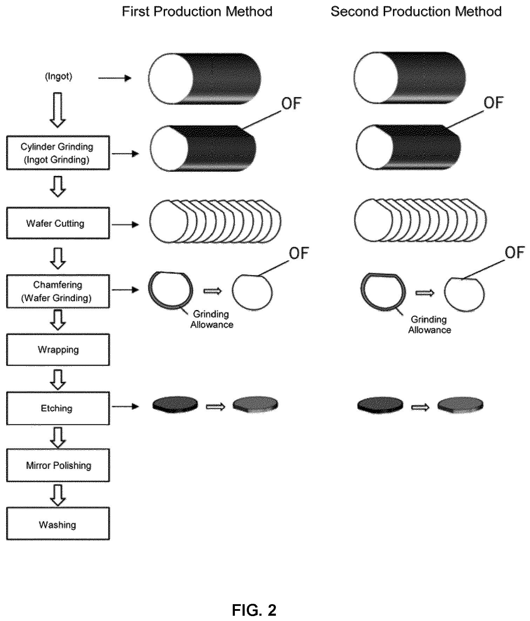

Next, a method for producing an indium phosphide substrate according to an embodiment of the present invention will be described. The method for producing the indium phosphide substrate according to the present invention includes a first production method and a second production method. FIG. 2 shows a schematic view of each step of the first and second production methods, and an ingot or a wafer produced in each of the steps.

### (First Production Method)

In the first production method for an indium phosphide substrate, first, an ingot of indium phosphide is prepared by a known method.

The ingot of indium phosphide is then ground into a cylinder at a grinding wheel feed rate of 20 to 35 mm/min using a grinding wheel having a grit size of #270 to #400, and an orientation flat (OF) is formed.

In the technical field to which the present invention belongs, the number used as the "grit size #" corresponds to a grain size of the grinding wheel; the larger the number of the grit size #, the smaller the grain size of the grinding wheel, and the smaller the number of the grit size, the larger the grain size of the grinding wheel.

The "grinding wheel feed rate" refers to a speed at which the wheel rotational axis moves relative to the ingot with the rotating wheel pressed against the ingot of indium phosphide for grinding.

Subsequently, at least one wafer having the main surface and the orientation flat is cut out from the ground indium phosphide ingot. In this case, both crystal ends of the ingot of indium phosphide are cut along a predetermined crystal plane using a wire saw or the like to cut out a plurality of wafers to have a predetermined thickness.

Subsequently, in each of the wafers, an outer circumference portion other than the end faces that form the orientation flat is chamfered. Here, the outer circumference portion other than the end faces that form the orientation flat are shown as "grinding allowance" in the chamfering (wafer grinding) step of the first production method in FIG. 4.

Subsequently, at least one surface, preferably both surfaces, of the chamfered wafer is polished. The polishing step is also called a lapping step, and the wafer is polished with certain abrasives to remove irregularities on the wafer surface.

Next, the polished wafer is etched under the following etching conditions:
- Etching Conditions

### [Composition of Etching Solution]

when the composition comprises 85% by mass of aqueous phosphoric acid solution and 30% by mass of hydrogen peroxide solution, the composition has a volume ratio of the aqueous phosphoric acid solution: the hydrogen peroxide of 0.2 to 0.4: 0.1, the balance being water so as to add up to 1 as the total etching solution;

### [Temperature of Etching Solution]

from 60 to 100 °C;

### [Etching Time]

from 8 to 15 minutes

The wafer is etched by immersing the entire wafer in the etching solution.

The main surface of the wafer is then polished with abrasives for mirror polishing to finish it into a mirror surface.

The resulting polished wafer is then washed to produce an indium phosphide wafer according to an embodiment of the present invention.

In the first production method for the indium phosphide substrate, the flatness of the orientation flat is controlled by optimizing the conditions for forming the orientation flat on the indium phosphide ingot and the etching conditions for the polished wafer.

### (Second Production Method)

In the second production method for an indium phosphide substrate, first, an ingot of indium phosphide is prepared by a known method.

The ingot of indium phosphide is then ground into a cylinder, and an orientation flat (OF) is formed.

At least one wafer having the main surface and the orientation flat is then cut out from the ground ingot of indium phosphide. In this case, both crystal ends of the ingot of indium phosphide are cut along a predetermined crystal plane using a wire saw or the like to cut out a plurality of wafers to have a predetermined thickness.

The end faces of the orientation flat on the wafer is then ground at a grinding wheel feed rate of 60 to 180 mm/min using a grinding wheel having a grit size of #800 to #1200. The "grinding wheel feed rate" refers to a speed at which the wheel rotational axis moves relative to the ingot with the rotating wheel pressed against the ingot of indium phosphide for grinding. The ground outer circumference portion in this step is the portion shown as "grinding allowance" in the chamfering (wafer grinding) step of the second production method in FIG 4, and only the end faces are ground without chamfering the orientation flat portion. The outer circumference portion other than the orientation flat portion is chamfered.

Subsequently, at least one surface, preferably both surfaces, of the chamfered wafer is polished. The polishing step is also called a lapping step, and the wafer is polished with a predetermined abrasive material to remove irregularities on the wafer surface.

Next, the polished wafer is etched under the following etching conditions:
- Etching Conditions

### [Composition of Etching Solution]

when the composition comprises 85% by mass of aqueous phosphoric acid solution and 30% by mass of hydrogen peroxide solution, the composition has a volume ratio of the aqueous phosphoric acid solution: the hydrogen peroxide of 0.2 to 0.4: 0.1, the balance being water so as to add up to 1 as the total etching solution;

### [Temperature of Etching Solution]

from 60 to 100 °C

### [Etching Time]

from 8 to 15 minutes

The wafer is etched by immersing the entire wafer in the etching solution.

The main surface of the wafer is then polished with an abrasive material for mirror polishing to finish it into a mirror surface.

The resulting polished wafer is then washed to produce an indium phosphide wafer according to an embodiment of the present invention.

In the second production method for the indium phosphide substrate, the flatness of the orientation flat is controlled by optimizing the conditions for grinding the end faces of the orientation flat on the wafer and the etching conditions for the polished wafer.

It should be noted that if the grinding of the end faces of the orientation flat on the wafer in the second production method for the indium phosphide substrate is simply carried out under the same conditions as, for example, the grinding in the first production method for the indium phosphide substrate as described above, or if the end faces are simply ground more finely, it is difficult to control the flatness of the orientation flat as in the indium phosphide substrate according to the embodiment of the present invention. This is because the grinding method is different between the ingot grinding and the wafer grinding, and in the wafer grinding, the wafer may vibrate in particular during grinding.

By epitaxially growing a semiconductor thin film onto the indium phosphide substrate according to the embodiment of the present invention by a known method, a semiconductor epitaxial wafer can be produced. As an example of the epitaxial growth, an InAIAs buffer layer, an InGaAs channel layer, an InAIAs spacer layer and an InP electron supply layer may be epitaxially grown onto the indium phosphide substrate to form a HEMT structure. When producing a semiconductor epitaxial wafer having such a HEMT structure, in general, a mirror-finished indium phosphide substrate is etched with an etching solution such as sulfuric acid/hydrogen peroxide solution to remove impurities such as silicon (Si) adhering to the substrate surface. In general, an amount removed by etching here is minute and does not change the flatness of the end face of the orientation flat portion. Then, on the etched indium phosphide substrate, an epitaxial film is formed by molecular beam epitaxy (MBE) or metal organic chemical vapor deposition (MOCVD).

### EXAMPLES

Hereinafter, Examples are provided for better understanding of the present invention and its advantages. However, the present invention is not limited to these Examples.

### Test Example 1

Based on the production flow of the first production method as described above, Examples 1 to 4 and Comparative Examples 1 to 4 were produced as follows:
First, ingots of monocrystals of indium phosphide grown to have a diameter of 80 mm or more were prepared.

The outer circumference of each ingot of each monocrystal of indium phosphide was ground into a cylinder and to form an orientation flat (OF). For the grinding of the outer circumference of the ingot, the grinding wheel employed the grit size # and metal bond as shown in Table 1, and the grinding wheel feed rate was set as shown in Table 1.

Next, the wafer having the main surface and the orientation flat was cut out from the ground ingot of indium phosphide. In this case, both crystal ends of the ingot of indium phosphide were cut along the predetermined crystal plane using a wire saw to cut out a plurality of wafers each having the predetermined thickness.

Subsequently, for each of the wafers, the outer circumference portion other than the end faces forming the orientation flat were chamfered.

Both sides of the chamfered wafer were then polished with abrasives to remove irregularities on the wafer surface.

The wafer was then immersed in an etching solution to etch the wafer at a specified temperature for a predetermined time. Table 1 shows the etching conditions. For the "APA Solution" shown in Table 1, 85 % by mass of aqueous phosphoric acid solution was used, for the "HP Solution", 30% by mass of hydrogen peroxide solution was used, and for "Sulfuric Acid", 96% by mass of sulfuric acid was used.

Next, the main surface of the wafer was polished to finish it with abrasives for mirror surface polishing to form a mirror surface, and then washed to produce an indium phosphide substrate having the wafer diameter, the wafer thickness and the length of the ridge line of the orientation flat.

### Test Example 2

As Example 5, an indium phosphide substrate was produced by the same method as in the above Examples 1 to 4, except for the following points 1) and 2):
1) An ingot of a monocrystal of indium phosphide grown to have a diameter of 104 mm or more was prepared.
2) The main surface of the wafer was polished with abrasives for mirror surface polishing to form a mirror surface, and then washed to produce an indium phosphide substrate having the wafer diameter, the wafer thickness and the length of the ridge line of the orientation flat as shown in Table 1.

### Test Example 3

Based on the production flow of the second production method as described above, Examples 6 to 9 and Comparative Examples 5 to 8 were produced as follows:
First, ingots of monocrystals of indium phosphide grown to have a diameter of 80 mm or more were prepared.

The outer circumference of each ingot of each monocrystal of indium phosphide was then ground into a cylinder and to form an orientation flat (OF). For the grinding of the outer circumference of the ingot, the grinding wheel employed the grit size # and metal bond as shown in Table 2, and the grinding wheel feed rate was set as shown in Table 2.

Next, the wafer having the main surface and the orientation flat was cut out from the ground ingot of indium phosphide. In this case, both crystal ends of the ingot of indium phosphide were cut along the predetermined crystal plane using a wire saw to cut out a plurality of wafers each having the predetermined thickness.

Subsequently, for each of the wafers, the end faces of the orientation flat were ground. The grinding wheel used for the grinding employed the grit size # shown in Table 2 and the grinding wheel feed rate shown in Table 2. The outer circumference portion other than the orientation flat portion was chamfered.

Both sides of the chamfered wafer were then polished with abrasives to remove irregularities on the wafer surface.

The wafer was then immersed in an etching solution to etch the wafer at a specified temperature for a predetermined time. Table 2 shows the etching conditions. For the "APA Solution" shown in Table 2, 85 % by mass of aqueous phosphoric acid solution was used, for the "HP Solution", 30% by mass of hydrogen peroxide solution was used, and for "Sulfuric Acid", 96% by mass of sulfuric acid was used.

Next, the main surface of the wafer was polished with abrasives for mirror surface polishing to form a mirror surface, and then washed to produce an indium phosphide substrate having the wafer diameter, the wafer thickness and the length of the ridge line of the orientation flat as shown in Table 2.

### Test Example 4

As Example 10, an indium phosphide substrate was produced by the same method as in Examples 6 to 9 described above, except for the following points 1) and 2):
1) An ingot of a monocrystal of indium phosphide grown to have a diameter of 104 mm or more was prepared.
2) The main surface of the wafer was polished with abrasives for mirror surface polishing to form a mirror surface, and then washed to produce an indium phosphide substrate having the wafer diameter, the wafer thickness and the length of the ridge line of the orientation flat as shown in Table 2.

### (Evaluation)

For each of the samples of Examples 1 to 10 and Comparative Examples 1 to 8, a surface excluding a width portion of 3 mm inward from both ends of the orientation flat end face was set in the longitudinal direction of the orientation flat end face. The four cross-sectional curves were then set at intervals of one-fifth of the thickness of the substrate (four cross-sectional curves in the a-, b-, c- and d-directions in total) as shown in FIG. 1. The maximum heights Pz of the four cross-sectional curves in the a-, b-, c-, and d-directions were measured in accordance with JIS B 0601: 2013. The difference between the maximum and minimum values of the maximum height Pz in each of the four cross-sectional curves in the a-, b-, c-, and d-directions was determined.

The production conditions as described above and the results of the evaluation are shown in Tables 1 and 2.

**Table 1**

| | | | Example 1 | Example 2 | Example 3 | Example 4 | Examples 5 | Comparative Example 1 | Comparative Example 2 | Comparative Example 3 | Comparative Example 4 |
|---|---|---|---|---|---|---|---|---|---|---|---|
| Wafer Shape (Final Shape) | Wafer Outer Diameter | (mm) | 76,2 | 76,2 | 76.2 | 76.2 | 100.0 | 76.2 | 76.2 | 76.2 | 76.2 |
| | Wafer Thickness | (µm) | 602 | 609 | 612 | 610 | 614 | 605 | 607 | 622 | 615 |
| | OF Length | (mm) | 22 | 22 | 22 | 22 | 32.5 | 22 | 22 | 22 | 22 |
| Ridge Line Forming Conditions | Ingot Outer | Grinding Wheel Grain Size | #400 | #270 | #400 | #400 | #400 | #270 | #200 | #270 | #270 |
| | Circumference Grinding | Grinding Wheel Feed Rate [mm/min] | 30 | 30 | 20 | 35 | 30 | 30 | 30 | 50 | 30 |
| | Wafer Outer | Grinding Wheel Grain Size | - | - | - | - | - | - | - | - | - |
| | Circumference Grinding | Grinding Wheel Feed Rate [mm/min] | - | - | - | - | - | - | - | - | - |
| | Etching Conditions | Solution Composition (volume ratio) | · APA Solution: 0.3 | · APA Solution: 0.3 | · APA Solution: 0.3 | · APA Solution: 0.3 | · APA Solution: 0.3 | · Sulfuric Acid: 0.7 | · APA Solution 0.3 | · APA Solution: 0.3 | · APA Solution: 0.9 |
| | | | · HPSolution: 0.1 | · HPSolution: 0.1 | · HPSolution: 0.1 | · HPSolution: 0.1 | · HPSolution: 0.1 | · HPSolution: 0.15 | · HPSolution: 0.1 | · HPSolution: 0.1 | · HPSolution: 0.1 |
| | | | · Water: 0.6 | · Water: 0.6 | · Water: 0.6 | · Water 0.6 | · Water: 0.6 | · Water: 0.15 | · Water: 0.6 | · Water: 0.6 | · Water: 0.0 |
| | | Solution Temperature [°C] | 70 | 70 | 70 | 70 | 70 | 70 | 70 | 70 | 70 |
| | | Etching (Immersing) Time [min] | 10 | 10 | 10 | 10 | 10 | 10 | 10 | 10 | 10 |
| Evaluation Results of Orientation Flat Flatness | Pz Value of Cross-Sectional Curve in a-Direction : Pz-a (µm) | | 5.20 | 7.08 | 5.17 | 6.04 | 10.06 | 10.30 | 5.88 | 12.00 | 7.32 |
| | Pz Value of Cross-Sectional Curve in b-Direction: Pz-b (µm) | | 6.00 | 6.32 | 5.13 | 6.72 | 9.26 | 7.15 | 10.04 | 10.15 | 6.20 |
| | Pz Value of Cross-Sectional Curve in c-Direction: Pz-c (µm) | | 6.20 | 9.07 | 5.69 | 7.42 | 9.73 | 9.28 | 6.68 | 14.39 | 10.16 |
| | Pz Value of Cross-Sectional Curve in d-Direction: Pz-d (µm) | | 6.50 | 8.13 | 5.03 | 6.43 | 6.94 | 6.25 | 8.27 | 11.50 | 8.95 |
| | Standard Deviation of the 4 Pz Values: Pz-0 (µm) | | 0.48 | 1.04 | 0.26 | 0.51 | 1.22 | 1.62 | 1.59 | 1.53 | 1.51 |
| | Maximum of the 4 Pz Values: Pz-max (µm) | | 6.50 | 9.07 | 5.69 | 7.42 | 10.06 | 10.30 | 10.04 | 14.39 | 10.16 |
| | Minimum of the 4 Pz Values: Pz-min (µm) | | 5.20 | 6.32 | 5.03 | 6.04 | 6.94 | 6.25 | 5.88 | 10.15 | 6.20 |
| | Difference between Maximum and Minimum (µm): Pz-R (µm) | | 1.30 | 2.75 | 0.66 | 1.38 | 3.13 | 4.05 | 4.16 | 4.23 | 3.96 |
| | Ratio of Pz-R to Longitudinal Length of Orientation Flat | | 0.591 | 1.252 | 0.300 | 0.628 | 0.962 | 1.841 | 1.889 | 1.924 | 1.798 |

**Table 2**

| | | | Example 6 | Example 7 | Example 8 | Example9 | Example 10 | Comparative Example 5 | Comparative Example 6 | Comparative Example 7 | Comparative Example 8 |
|---|---|---|---|---|---|---|---|---|---|---|---|
| Wafer Shape (Final Shape) | Water Outer Diameter | (mm) | 76.2 | 76.2 | 76.2 | 762 | 100.0 | 76.2 | 762 | 76.2 | 76.2 |
| | Diameter Wafer Thickness | (µm) | 624 | 614 | 606 | 619 | 613 | 627 | 616 | 625 | 604 |
| | OF Length | (mm) | 22 | 22 | 22 | 22 | 32.5 | 22 | 22 | 22 | 22 |
| Ridge Line Forming Conditions | Ingot Outer | Grinding Wheel Grain Size | #400 | #400 | #400 | #400 | #400 | #400 | #400 | #400 | #400 |
| | Circumference Grinding | Grinding Wheel Feed Rate [mm/min] | 30 | 30 | 30 | 30 | 30 | 30 | 30 | 30 | 30 |
| | Wafer Outer | Grinding Wheel Grain Size | #1200 | #800 | #1200 | #1200 | #1200 | #800 | #400 | #800 | #800 |
| | Circumference Grinding | Grinding Wheel Feed Rate [mm/min] | 90 | 90 | 60 | 180 | 90 | 90 | 90 | 900 | 90 |
| | Etching Conditions | Solution Composition (volume ratio) | · APA Solution: 0.3 | · APA Solution: 0.3 | · APA Solution 0.3 | · APA Solution: 0.3 | · APA Solution: 0.3 | · Sulfuric Acid: 0.7 | · APA Solution: 0.3 | · APA Solution: 0.3 | · APA Solution: 0.9 |
| | | | · HPSolution: 0,1 | · HPSolution: 0.1 | · HPSolution: 0.1 | · HPSolution: 0.1 | · HPSolution: 0.1 | · HPSolution: 0.15 | · HPSolution: 0.1 | · HPSolution: 0.1 | · HPSolution: 0.1 |
| | | | · Water: 0,6 | · Water: 0.6 | · Water: 0.6 | · Water: 0.6 | · Water: 0.6 | · Water: 0.15 | · Water: 0.6 | · Water: 0.6 | · Water: 0.0 |
| | | Solution Temperature [°C] | 70 | 70 | 70 | 70 | 70 | 70 | 70 | 70 | 70 |
| | | Etching (Immersing) Time [min] | 10 | 10 | 10 | 10 | 10 | 10 | 10 | 10 | 10 |
| | Pz value of Cross-Sectional Curve in a-Direction: Pz-a (µm) Pz-a Value | | 8.20 | 8.34 | 7.89 | 8.31 | 6.28 | 12.34 | 12.80 | 15.84 | 7.30 |
| | of Cross-Sectional Curve in b-Direction: Pz-b (µm) | | 6.40 | 7.39 | 6.60 | 6.48 | 8.42 | 15.12 | 14.66 | 13.15 | 6.67 |
| | Pz Value of Cross-Sectional Curve in c-Direction: Pz-c (µm) | | 7.90 | 10.49 | 7.28 | 7.35 | 7.28 | 11.04 | 13.70 | 14.96 | 7.75 |
| | Pz Value of Cross-Sectional Curve in d-Direction: Pz-d (µm) | | 6.30 | 9.18 | 6.78 | 9.31 | 6.33 | 11.09 | 10.46 | 11.78 | 10.63 |
| Evaluation Results of Orientation Flat Flatness | Standard Deviation of the 4 Pz Values: Pz-o (µm) | | 0.86 | 1.14 | 0.50 | 1.06 | 0.87 | 1.65 | 1.56 | 1.58 | 1.52 |
| | Maximum of the 4 Pz Values: Pz-max (µm) | | 8.20 | 10.49 | 7.89 | 9.31 | 8.42 | 15.12 | 14.66 | 15.84 | 10.63 |
| | Minimum of the 4 Pz Values: Pz-min (µm) | | 6.30 | 7.39 | 6.60 | 6.48 | 6.28 | 11.04 | 10.46 | 11.78 | 6.67 |
| | Difference between Maximum and Minimum (µm): Pz-R (µm) | | 1.90 | 3.10 | 1.29 | 2.83 | 2.14 | 4.08 | 4.20 | 4.06 | 3.97 |
| | Ratio of Pz-R to Longitudinal Length of Orientation Flat | | 0.864 | 1.409 | 0.587 | 1.288 | 0.658 | 1.852 | 1.909 | 1.844 | 1.803 |

### (Evaluation Results)

In each of Examples 1 to 10, the difference between the maximum value and the minimum value of the maximum height Pz in each of the four cross-sectional curves was 1.50/10000 or less of the longitudinal length of the orientation flat end face, and it provided an indium phosphide substrate having good flatness accuracy of the orientation flat.

In each of Comparative Examples 1, 4, 5, and 8, the composition of the solution used for the etching process was not appropriate for the ridge line forming conditions, and the difference between the maximum value and the minimum value of the maximum height Pz in each of the four cross-sectional curves was more than 1.50/10000 or less of the longitudinal length of the orientation flat end face.

In Comparative Example 2, the grain size of the grinding wheel used for the outer circumference grinding of the ingot was not appropriate for the ridge line forming conditions, and the difference between the maximum value and the minimum value of the maximum height Pz in each of the four cross-sectional curves was more than 1.50/10000 or less of the longitudinal length of the orientation flat end face.

In Comparative Example 3, the grinding wheel feed rate set for the outer circumference grinding of the ingot was not appropriate for the ridge line forming conditions, and the difference between the maximum value and the minimum value of the maximum height Pz in each of the four cross-sectional curves was more than 1.50/10000 or less of the longitudinal length of the orientation flat end face.

In Comparative Example 6, the grain size of the grinding wheel used for the outer circumference grinding of the wafer was not appropriate for the ridge line forming conditions, and the difference between the maximum value and the minimum value of the maximum height Pz in each of the four cross-sectional curves was more than 1.50/10000 or less of the longitudinal length of the orientation flat end face.

In Comparative Example 7, the grinding wheel feed rate set for the outer circumference grinding of the wafer was not appropriate for the ridge line forming conditions, and the difference between the maximum value and the minimum value of the maximum height Pz in each of the four cross-sectional curves was more than 1.50/10000 or less of the longitudinal length of the orientation flat end face.

### Description of Reference Numerals

- 10: indium phosphide substrate
- 11: main surface
- 12: orientation flat
- 13: ridge line

## Claims

1. An indium phosphide substrate having a main surface and an orientation flat,
wherein a difference between maximum and minimum values of a maximum height Pz in each of four cross-sectional curves is less than or equal to 1.50/10000 of a length in a longitudinal direction of an orientation flat end face, wherein the four cross-sectional curves are set at intervals of one-fifth of a thickness of the substrate on a surface excluding a width portion of 3 mm inward from both ends of the orientation flat end face in the longitudinal direction of the orientation flat end face, and the maximum height Pz in each of the four cross-sectional curves is measured in accordance with JIS B 0601: 2013.

2. The indium phosphide substrate according to claim 1, wherein the difference between the maximum and minimum values of the maximum height Pz in each of the four cross-sectional curves is less than or equal to 1.41/10000 of the length in the longitudinal direction of the orientation flat end face.

3. An indium phosphide substrate having a main surface and an orientation flat,
wherein a standard deviation σ of maximum heights Pz in four cross-sectional curves is less than or equal to 1.50 µm or less, wherein the four cross-sectional curves are set at intervals of one-fifth of a thickness of the substrate on a surface excluding a width portion of 3 mm inward from both ends of the orientation flat end face in a longitudinal direction of an orientation flat end face, and the maximum height Pz in each of the four cross-sectional curves is measured in accordance with JIS B 0601: 2013.

4. The indium phosphide substrate according to claim 3, wherein the standard deviation σ of the maximum heights Pz in the four cross-sectional curves is less than or equal to 1.22 µm.

5. The indium phosphide substrate according to any one of claims 1 to 4, wherein the indium phosphide substrate has a thickness of from 300 to 900 µm.

6. The indium phosphide substrate according to any one of claims 1 to 5, wherein a length of a ridge line which is a line where the main surface is in contact with the orientation flat is from 8 to 50% of a diameter of the main surface.

7. The indium phosphide substrate according to claim 6, wherein an outer edge of the main surface comprises the orientation flat and a circular arc portion connected to the orientation flat, and wherein a maximum diameter of the main surface is more than or equal to the length of the ridge line, and is from 49 to 151 mm.

8. A method for producing an indium phosphide substrate, comprising the steps of:
grinding an ingot of indium phosphide at a grinding wheel feed rate of 20 to 35 mm/min using a grinding wheel having a grit size of #270 to #400 to form an orientation flat;
cutting out at least one wafer having a main surface and an orientation flat from the ground ingot of indium phosphide;
chamfering an outer circumference portion of the wafer other than end faces of forming the orientation flat;
polishing at least one surface of the chamfered wafer; and
etching the polished wafer under the following etching conditions:
- etching conditions:
(Composition of Etching Solution)
when the composition comprises 85% by mass of aqueous phosphoric acid solution and 30% by mass of hydrogen peroxide solution, the composition has a volume ratio of the aqueous phosphoric acid solution: the hydrogen peroxide of 0.2 to 0.4: 0.1,
the balance being water so as to add up to 1 as the total etching solution;
(Temperature of Etching Solution)
from 60 to 100 °C;
(Etching Time)
from 8 to 15 minutes.

9. A method for producing an indium phosphide substrate, comprising the steps of:
grinding an ingot of indium phosphide to form an orientation flat;
cutting out at least one wafer having a main surface and an orientation flat from the ground ingot of indium phosphide;
griding end faces of the orientation flat on the wafer at a grinding wheel feed rate of 60 to 180 mm/min using a grinding wheel having a grit size of #800 to #1200 and chamfering an outer circumference portion other than the orientation flat;
polishing at least one surface of the chamfered wafer; and
etching the polished wafer under the following etching conditions:
- etching conditions:
(Composition of Etching Solution)
when the composition comprises 85% by mass of aqueous phosphoric acid solution and 30% by mass of hydrogen peroxide solution, the composition has a volume ratio of the aqueous phosphoric acid solution: the hydrogen peroxide of 0.2 to 0.4: 0.1,
the balance being water so as to add up to 1 as the total etching solution;
(Temperature of Etching Solution)
from 60 to 100 °C;
(Etching Time)
from 8 to 15 minutes.
